(19)

Europäisches
Patentamt

European
Patent Office

Office européen
des brevets

(11)     EP 4 280 831 A1

(12)     EUROPEAN PATENT APPLICATION
published in accordance with Art. 153(4) EPC

(43) Date of publication:
22.11.2023 Bulletin 2023/47

(21) Application number: 21920645.5

(22) Date of filing: 29.09.2021

(51) International Patent Classification (IPC):
*H05K 7/20* (2006.01)

(52) Cooperative Patent Classification (CPC):
Y02T 30/00

(86) International application number:
PCT/CN2021/121624

(87) International publication number:
WO 2022/156267 (28.07.2022 Gazette 2022/30)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 20.01.2021 CN 202110076418

(71) Applicant: CRRC Zhuzhou Locomotive Co., Ltd.
Zhuzhou, Hunan 412001 (CN)

(72) Inventors:
• FAN, Yunxin
Zhuzhou, Hunan 412001 (CN)
• MAO, Yejun
Zhuzhou, Hunan 412001 (CN)
• LIU, Qiang
Zhuzhou, Hunan 412001 (CN)

• ZHU, Maohua
Zhuzhou, Hunan 412001 (CN)
• YI, Ke
Zhuzhou, Hunan 412001 (CN)
• YANG, Tianzhi
Zhuzhou, Hunan 412001 (CN)
• LI, Shilin
Zhuzhou, Hunan 412001 (CN)
• LI, Shimin
Zhuzhou, Hunan 412001 (CN)
• XU, Li
Zhuzhou, Hunan 412001 (CN)
• YANG, Sheng
Zhuzhou, Hunan 412001 (CN)
• CHEN, Shiwen
Zhuzhou, Hunan 412001 (CN)
• FU, Yu
Zhuzhou, Hunan 412001 (CN)

(74) Representative: Alpspitz IP
Longinusstraße 1
81247 München (DE)

(54)     **RAIL TRAIN, RAIL TRAIN HEAT DISSIPATION SYSTEM, AND HEAT DISSIPATION METHOD
THEREOF**

(57)     Disclosed in the present invention are a rail train, a rail train heat dissipation system, and a heat dissipation method thereof. Absorbed heat of a heat generation device is brought into a traveling air heat dissipation apparatus by means of flowing of a liquid heat conduction medium in a pipeline, traveling air generated when a train runs at a high speed is used to dissipate heat of the liquid heat conduction medium storing the heat, the cooled liquid heat conduction medium flows back into a heat taking apparatus for heat collection, and the circulation is carried out in this way, such that heat dissipation of the heat generation device is realized. The temperature of the liquid heat conduction medium is measured by means of a temperature sensor, and the number of starting heat dissipation modules in the traveling air heat dissipation apparatus and/or the flow rate of the liquid heat conduction medium in the traveling air heat dissipation apparatus are/is controlled according to the temperature, such that the temperature of the liquid heat conduction medium at an outlet or an inlet of the heat taking apparatus is within a threshold range, and the balance control of the heat generation amount and the heat dissipation amount is achieved. The heat dissipation performance is remarkably improved, the outstanding performances of saving energy and reducing noise and cost are achieved, and the volume and weight of the heat dissipation apparatus are greatly decreased.

EP 4 280 831 A1

**(Cont. next page)**

Figure 1

Description

Field of the Invention

The present invention belongs to the field of ventilation and cooling design for rail vehicles, in particular to a rail train, a rail train heat dissipation system, and a heat dissipation method thereof.

Background of the Invention

A ventilation and cooling system is an important component of a railway vehicle for cooling a traction system (such as a main transformer, a main converter cabinet, and a traction motor, etc.) to ensure safe operation of the traction system. With the rapid development of technology, power and power density of electrical appliances such as transformers, converters, and traction motors on locomotives are continuously increasing, resulting in continuous increases in required heat dissipation and cooling power. If conventional on-board cooling towers are continued to be used, their heat dissipation value, volume, weight, noise, and the like hardly meet requirements of high-quality locomotives. Therefore, how to solve a problem of increasing heat of electrical appliances in locomotives is a technical difficulty urgently to be solved in the industry.

Summary of the Invention

The objective of the present invention is to provide a rail train, a rail train heat dissipation system, and a heat dissipation method thereof, to solve problems of increasing heat generation of locomotive electrical appliances and increasing requirements for heat dissipation and cooling, and to achieve efficient, energy-saving, and environment-friendly locomotive heat dissipation.

The present invention solves the foregoing technical problems through the following technical solutions: A rail train heat dissipation system includes:

a heat extraction apparatus used for collecting heat of heat generation devices and storing the heat in a liquid heat-conducting medium;
a temperature sensor disposed at an outlet or inlet of the heat extraction apparatus and used for detecting the temperature of the liquid heat-conducting medium in the outlet or inlet;
a heat transfer apparatus connected to the heat extraction apparatus and used for transferring the liquid heat-conducting medium with stored heat to the heat dissipation apparatus and transferring the cooled liquid heat-conducting medium to the heat extraction apparatus;
a traveling air heat dissipation apparatus connected to the heat transfer apparatus and used for dissipate heat of the incoming liquid heat-conducting medium; and

a regulating apparatus used for controlling an opening quantity of heat dissipation modules in the traveling air heat dissipation apparatus and/or a flow rate of the liquid heat-conducting medium in the traveling air heat dissipation apparatus according to the temperature of the liquid heat-conducting medium in the outlet or inlet of the heat extraction apparatus, such that the temperature of the liquid heat-conducting medium in the outlet or inlet of the heat extraction apparatus is within a threshold range, and balance control on a heat generation value and a heat dissipation value is achieved.

In the present invention, the liquid heat-conducting medium absorbs heat of the heat generation devices, the heat is brought into the traveling air heat dissipation apparatus by means of flowing of the liquid heat-conducting medium in a pipeline, traveling air generated when a train runs at a high speed is used to dissipate heat of the liquid heat-conducting medium with stored heat to obtain cooled liquid heat-conducting medium, the cooled liquid heat-conducting medium flows back into the heat extraction apparatus for heat collection, and the circulation is carried out in this way, such that heat dissipation of the heat generation devices is realized. The temperature of the liquid heat-conducting medium is detected through the temperature sensor; when the temperature is higher than a threshold range, the opening quantity of heat dissipation modules and/or the flow rate of the liquid heat-conducting medium are increased; or when the temperature is lower than the threshold range, the opening quantity of heat dissipation modules and/or the flow rate of the liquid heat-conducting medium are decreased, such that the heat generated by all the heat generation devices and the heat dissipation value achieve a balance, and the heat generation devices work within a suitable working temperature. According to the system, no power is needed on an air side of the traveling air heat dissipation apparatus, a heat dissipation effect that a conventional fan or cooling tower cannot achieve is achieved without increasing the volume of the heat dissipation apparatus, the heat dissipation performance is remarkably improved, outstanding performances of saving energy and reducing noise and cost are achieved, and the volume and weight of the heat dissipation apparatus are greatly decreased. The system controls the opening quantity of heat dissipation modules and the flow rate of the liquid heat-conducting medium according to the principle of heat balance, and provides a reasonable and efficient regulating method for the balance between the heat generation value and the heat dissipation value, such that the heat generation devices work within a reasonable temperature range, and safe operation of the train is ensured.

Further, the traveling air heat dissipation apparatus includes a plurality of heat dissipation branches; each heat dissipation branch includes a plurality of heat dissipation modules connected in series or in parallel or in series and parallel; an input valve is disposed at an input end of each heat dissipation branch, and an output valve is disposed at an output end of each heat dissipation branch; and the input end of each heat dissipation branch is connected to a heat-conducting pipeline of the heat transfer apparatus, and the output end of each heat dissipation branch is connected to a return pipeline of the heat transfer apparatus.

The traveling air heat dissipation apparatus has a distributed structure to achieve centralized heat collection and distributed heat dissipation. The potential for heat dissipation is maximized, at the same time, the heat dissipation modules back up each other to greatly improve the reliability of the heat dissipation apparatus. Each heat dissipation branch works in a centralized and distributed heat dissipation manner, thereby achieving an efficient and energy-saving heat dissipation effect.

Preferably, the traveling air heat dissipation apparatus is disposed at a roof, bottom, or side wall of a train.

The mounting position does not need to occupy a special position of the train, thereby saving space and reducing noise effect of the heat dissipation apparatus on the interior of the train.

Further, the heat dissipation module is a plate fin heat exchanger.

Further, the heat dissipation module is a phase change heat dissipation apparatus, which includes a lower cavity, flow pipelines disposed in the lower cavity, an upper cavity disposed on the lower cavity, and multiple layers of phase change heat pipes stacked in parallel; an evaporation section of the phase change heat pipe is disposed in the lower cavity, and a condensation section of the phase change heat pipe is disposed in the upper cavity; and fins are disposed on the condensation section of the phase change heat pipe and between two adjacent layers of phase change heat pipes; and at least some of the fins are located in an air duct, and the fins are cooled by means of traveling air.

The liquid heat-conducting medium with stored heat flows into the lower cavity through the flow pipelines and transfers the heat to the evaporation sections of the phase change heat pipes in the lower cavity, the heat is then transferred to the fins through the condensation sections of the phase change heat pipes, finally the heat on the fins is carried away through traveling air to reduce the temperature of the liquid heat-conducting medium and realize cooling of the liquid heat-conducting medium, and the cooled liquid heat-conducting medium flows out of the lower cavity. The phase change heat dissipation apparatus greatly improves the heat dissipation rate and effect through a heat transfer path of "liquid heat-conducting medium - phase change working medium - traveling air".

Further, the heat dissipation system further includes a vehicle-mounted cooling apparatus connected to the heat transfer apparatus; and the regulating apparatus is further used for calculating total heat generation power of all the heat generation devices, and controlling the traveling air heat dissipation apparatus to open or the traveling air heat dissipation apparatus and the vehicle-mounted cooling apparatus to open according to the total heat generation power.

The cooperation of the traveling air heat dissipation apparatus and the vehicle-mounted cooling apparatus ensures a heat dissipation effect when the train is started or is at a low speed, achieves an efficient and good heat dissipation effect in a case of minimum energy consumption, and achieves energy conservation and environmental protection while ensuring the heat dissipation effect.

The present invention further provides a method for dissipating heat by using the heat dissipation system described above, including the following steps:

> step 1: collecting heat generated by the heat generation devices and storing the heat in a liquid heat-conducting medium;
> step 2: obtaining the temperature of the liquid heat-conducting medium in the outlet or inlet of the heat extraction apparatus; and
> step 3: controlling an opening quantity of heat dissipation modules in the traveling air heat dissipation apparatus and/or a flow rate of the liquid heat-conducting medium in the traveling air heat dissipation apparatus according to the temperature of the liquid heat-conducting medium in the outlet or inlet of the heat extraction apparatus, such that the temperature of the liquid heat-conducting medium in the outlet or inlet of the heat extraction apparatus is within a threshold range, and balance control on a heat generation value and a heat dissipation value is achieved.

Further, in step 3, a process of controlling an opening quantity of heat dissipation modules and/or a flow rate of the liquid heat-conducting medium is as follows:

> when the temperature of the liquid heat-conducting medium in the outlet or inlet of the heat extraction apparatus is higher than a maximum value of the threshold range, increasing the opening quantity of heat dissipation modules and/or increasing the flow rate of the liquid heat-conducting medium; or
> when the temperature of the liquid heat-conducting medium in the outlet or inlet of the heat extraction apparatus is lower than a minimum value of the threshold range, decreasing the opening quantity of heat dissipation modules and/or decreasing the flow rate of the liquid heat-conducting medium, where the threshold range is set according to a working temperature range of the heat generation devices.

Further, after step 1 and before step 3, the method further includes:

calculating total heat generation power of all the heat generation devices;

controlling the traveling air heat dissipation apparatus to open or the traveling air heat dissipation apparatus and the vehicle-mounted cooling apparatus to open according to the total heat generation power; and

performing step 3 when only the traveling air heat dissipation apparatus is opened; or when both the traveling air heat dissipation apparatus and the vehicle-mounted cooling apparatus are opened, controlling all heat dissipation modules in the traveling air heat dissipation apparatus to be opened, controlling the flow rate of the liquid heat-conducting medium in the traveling air heat dissipation apparatus to be maximum, and controlling heat dissipation power of the vehicle-mounted cooling apparatus according to the temperature of the liquid heat-conducting medium in the outlet or inlet of the heat extraction apparatus, such that the temperature of the liquid heat-conducting medium in the outlet or inlet of the heat extraction apparatus is within the threshold range, and the balance control on the heat generation value and the heat dissipation value is achieved.

Further, an expression for calculating the total heat generation power is:

$$P_{cr}(v) = \lambda \times F(v) \times v$$

where $P_{cr}(v)$ is total heat generation power corresponding to a traveling speed, F(v) is train traction force corresponding to the traveling speed, v is a traveling speed of the train, $\lambda$ is a power loss coefficient, and a value range of $\lambda$ is 0.5%-30% according to different vehicle models.

The present invention further provides a rail train, including the heat dissipation system as described above.

Beneficial effects are as follows:

Compared with the existing technologies, the rail train, the rail train heat dissipation system, and the heat dissipation method provided in the present invention have the beneficial effects that no power is needed on the air side of the traveling air heat dissipation apparatus, a heat dissipation effect that a conventional fan or cooling tower cannot achieve is achieved without increasing the volume of the heat dissipation apparatus, the heat dissipation performance is remarkably improved, outstanding performances of saving energy and reducing noise and cost are achieved, and the volume and weight of the heat dissipation apparatus are greatly decreased; and the opening quantity of heat dissipation modules and/or the flow rate of the liquid heat-conducting medium are controlled according to the principle of heat balance, and a reasonable and efficient regulating method is provided for a balance between a heat generation value and a heat dissipation value, such that the heat generation devices work within a reasonable temperature range, and safe operation of the train is ensured.

**Brief Description of the Drawings**

In order to illustrate the technical solutions of the present invention more clearly, the following briefly introduces the accompanying drawings used in the description of the embodiments. Obviously, the drawings in the following description are only an embodiment of the present invention, and those of ordinary skill in the art can obtain other drawings according to the drawings without any creative effort.

FIG. 1 is a schematic structural diagram of a rail train heat dissipation system in Embodiment 1 of the present invention;
FIG. 2 is a schematic diagram of parallel connection of heat dissipation modules in heat dissipation branches in Embodiment 1 of the present invention;
FIG. 3 is a schematic diagram of series and parallel connection of heat dissipation modules in heat dissipation branches in Embodiment 1 of the present invention;
FIG. 4 is a schematic structural diagram of a phase change heat dissipation apparatus in Embodiment 1 of the present invention;
FIG. 5 shows relationship curves between heat generation power and heat dissipation power of a heat dissipation apparatus under a rated condition and a traveling speed of a train in Embodiment 1 of the present invention;
FIG. 6 is a schematic structural diagram of a rail train heat dissipation system in Embodiment 2 of the present invention; and
FIG. 7 is a schematic diagram of disposal of the heat dissipation system on the rail train in Embodiment 2 of the present invention.

In the figures: 1 - heat generation device, 2 - heat extraction apparatus, 3 - traveling air heat dissipation apparatus, 31 - input valve, 32 - output valve, 33 - heat dissipation module, 331 - flow pipeline, 332 - lower cavity, 333 - phase change heat pipe, 334 - fin, 335 - upper cavity, 4 - heat transfer apparatus, 41 - heat-conducting pipeline, 42 - return pipeline, 43 - circulating pump, 44 - first valve, 45 - second valve, 46 - third valve, 47 - fourth valve, 5 - vehicle-mounted cooling apparatus, 51 - fan, 52 - cooling tower heat exchanger, 6 - rail train, T1 - temperature of liquid heat-conducting medium in the inlet of the heat extraction apparatus, T2 - temperature of liquid heat-conducting medium in the outlet of the heat extraction apparatus.

**Detailed Description of the Embodiments**

A clear and complete description will be made to the technical solutions in the present invention below with reference to the accompanying drawings in the embodiments of the present invention. Apparently, the embodiments described are only part of the embodiments of the present invention, not all of them. All other embodiments obtained by those of ordinary skill in the art based on the embodiments of the present invention without any creative effort shall fall within the protection scope of the present invention.

**Embodiment 1**

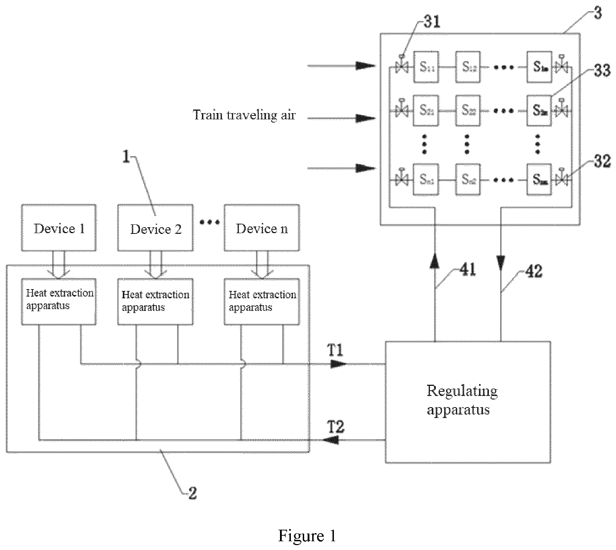

As shown in FIG. 1, a rail train heat dissipation system provided in this embodiment includes a heat extraction apparatus 2, a temperature sensor, a heat transfer apparatus 4, a traveling air heat dissipation apparatus 3, and a regulating apparatus. The heat extraction apparatus 2, the heat transfer apparatus 4, and the traveling air heat dissipation apparatus 3 are connected sequentially. The temperature sensor is disposed at an outlet or inlet of the heat extraction apparatus 2. The regulating apparatus controls opening of valves in the heat transfer apparatus 4 and the traveling air heat dissipation apparatus 3 according to the temperature, collected by the temperature sensor of a liquid heat-conducting medium in the outlet or inlet of the heat extraction apparatus 2, so as to control a flow rate of the liquid heat-conducting medium in the traveling air heat dissipation apparatus 3; and the regulating apparatus controls an opening quantity of heat dissipation modules 33 in the traveling air heat dissipation apparatus 3 according to the temperature, collected by the temperature sensor of the liquid heat-conducting medium in the outlet or inlet of the heat extraction apparatus 2. The temperature of the liquid heat-conducting medium in the outlet or inlet of the heat extraction apparatus 2 is within a threshold range by controlling the flow rate and the opening quantity of heat dissipation modules 33, such that heat generation devices 1 work within a suitable temperature range, and balance control on a heat generation amount and a heat dissipation value is achieved.

The heat extraction apparatus 2 is composed of a pipeline that is in close contact with a heat source in the heat generation device 1, the pipeline being filled with a liquid heat-conducting medium. The liquid heat-conducting medium absorbs heat generated by the heat source and stores the heat in the liquid heat-conducting medium, the heat is then brought into the traveling air heat dissipation apparatus 3 by means of flowing of the liquid heat-conducting medium in the pipeline, the heat in the liquid heat-conducting medium is carried away through traveling air to realize cooling of the liquid heat-conducting medium, the cooled liquid heat-conducting medium flows back to the heat extraction apparatus 2, and the circulation is carried out in this way, such that heat dissipation of the heat generation device 1 is realized, and the heat generation device 1 is always kept in a reasonable working temperature range.

In this embodiment, the liquid heat-conducting medium can be oil, water, antifreeze, coolant, or other cooling medium.

The temperature sensor is mounted at the outlet or inlet of the heat extraction apparatus 2 to collect the temperature of the liquid heat-conducting medium inside the outlet or inlet of the heat extraction apparatus 2, thereby providing a reference basis for subsequent control and regulation. The outlet or inlet of the heat extraction apparatus 2 is relative to the heat transfer apparatus 4, a pipe orifice where the liquid heat-conducting medium flows from the heat extraction apparatus 2 to the heat transfer apparatus 4 is the outlet, and a pipe orifice where the liquid heat-conducting medium flows from the heat transfer apparatus 4 to the heat extraction apparatus 2 is the inlet. The liquid heat-conducting medium flowing to the heat extraction apparatus 2 is a cooled medium, so the inlet temperature $T_2$ is lower than the outlet temperature $T_1$. The threshold range is set according to the working temperature range of the heat generation device 1, and a type of devices with the same or similar working temperature range corresponds to a set of heat dissipation system in this embodiment. For example, the temperature sensor is disposed at the outlet of the heat extraction apparatus 2, the threshold range of the heat generation device such as a converter is $61°C \pm 1°C$, and the threshold range of the heat generation device such as a transformer is $81°C \pm 1°C$. The threshold range at the inlet of the heat extraction apparatus 2 is generally about 5°C different from the threshold range at its outlet. For example, when the threshold range at the outlet is 60°C-62°C, the threshold range at the inlet is 55°C-57°C.

When the temperature of the liquid heat-conducting medium in the outlet or inlet of the heat extraction apparatus 2 is higher than a maximum value of the threshold range, the opening quantity of heat dissipation modules 33 in the traveling air heat dissipation apparatus 3 and/or the flow rate of the liquid heat-conducting medium in the traveling air heat dissipation apparatus 3 are increased to increase the heat dissipation value and keep the temperature within the threshold range; or when the temperature of the liquid heat-conducting medium in the outlet or inlet of the heat extraction apparatus 2 is lower than a minimum value of the threshold range, the opening quantity of heat dissipation modules 33 in the traveling air heat dissipation apparatus 3 and/or the flow rate of the liquid heat-conducting medium in the traveling air heat dissipation apparatus 3 are decreased to decrease the heat dissipation value and keep the temperature within the threshold range. In this way, the heat generation device 1 is enabled to work within a reasonable working temperature range, safe operation of the train is ensured, energy is saved, the environment is protected, and a balance between heat generation and heat dissipation is achieved.

The heat transfer apparatus 4 includes a heat-conducting pipeline 41, a return pipeline 42, a first valve and a second valve that are disposed on the heat-conducting pipeline 41 and the return pipeline 42 separately, and a circulating pump disposed on the heat-conducting pipeline 41. The heat-conducting pipeline 41 is connected to the outlet of the heat extraction apparatus 2, the return pipeline 42 is connected to the inlet of the heat extraction apparatus 2, and the circulating pump 43 provides power for the liquid heat-conducting medium to flow into the traveling air heat dissipation apparatus 3. The regulating apparatus controls the opening and closing of the first valve and the second valve, such that the liquid heat-conducting medium with stored heat flows into the traveling air heat dissipation apparatus 3 through the heat-conducting pipeline 41, and the cooled liquid heat-conducting medium flows into the heat extraction apparatus 2 through the return pipeline 42.

As shown in FIG. 1, the traveling air heat dissipation apparatus 3 includes $n$ heat dissipation branches; each heat dissipation branch includes $m$ heat dissipation modules 33 sequentially connected in series; an input valve 31 is disposed at an input end of each heat dissipation branch, and an output valve 32 is disposed at an output end of each heat dissipation branch; and the input end of each heat dissipation branch is connected to the heat-conducting pipeline 41 of the heat transfer apparatus 4, and the output end of each heat dissipation branch is connected to the return pipeline 42 of the heat transfer apparatus 4. The regulating apparatus controls opening, closing, and opening sizes of the input valve 31 and the output valve 32 on each heat dissipation branch, so as to control an opening quantity of the heat dissipation branches and the flow rate of the liquid heat-conducting medium in each heat dissipation branch, thereby regulating the heat dissipation value, keeping the temperature of the liquid heat-conducting medium in the outlet or inlet of the heat extraction apparatus 2 within the threshold range, and achieving a balance between heat generation and heat dissipation.

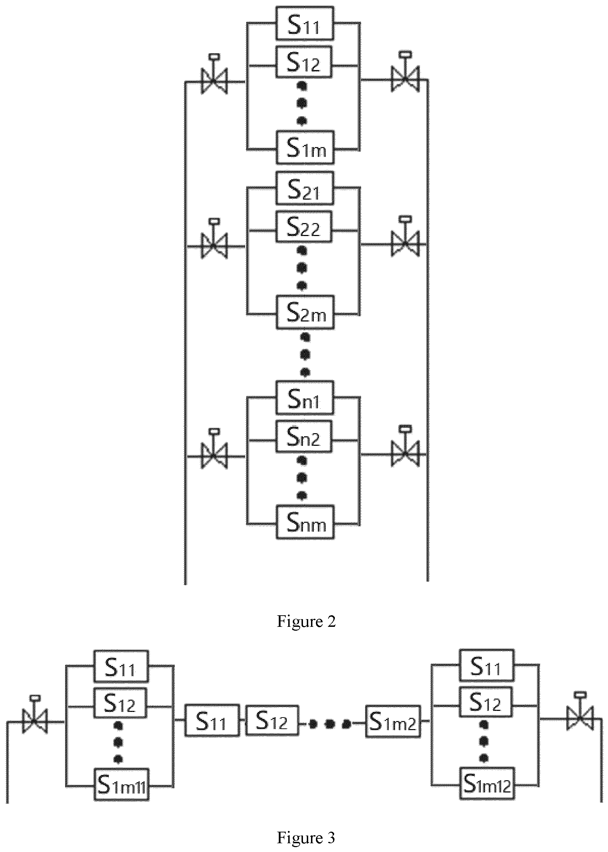

A second implementation of the heat dissipation branches is as follows: Each heat dissipation branch includes $m$ heat dissipation modules connected in parallel, as shown in FIG. 2. A third implementation of the heat dissipation branches is as follows: Each heat dissipation branch includes $m$ heat dissipation modules, where $m_1$ heat dissipation modules are connected in parallel, $m_2$ heat dissipation modules are connected in series, and $m_1+m_2=m$. As shown in FIG. 3, the heat dissipation modules include three parts, where the first part is composed of $m_{11}$ heat dissipation modules connected in parallel, the second part is composed of $m_2$ heat dissipation modules connected in series, the third part is composed of $m_{12}$ heat dissipation modules connected in parallel, and $m_{11}+m_{12}=m_1$. The third implementation of the heat dissipation branches can be any combination of series and parallel connections according to actual needs.

The traveling air heat dissipation apparatus 3 has a distributed structure to achieve centralized heat collection and distributed heat dissipation. The potential for heat dissipation is maximized, at the same time, the heat dissipation branches back up each other, thereby greatly improving the reliability of the heat dissipation apparatus. Each heat dissipation branch works in a centralized and distributed heat dissipation manner, thereby achieving an efficient and energy-saving heat dissipation effect. The traveling air heat dissipation apparatus 3 dissipates heat by means of traveling air and has no high-power moving components, so the safety is high; large fans are not needed, so noise is reduced and energy consumption is remarkably reduced; and the weight of the traveling air heat dissipation apparatus 3 is half that of a vehicle-mounted cooling tower, which contributes to weight reduction of the train.

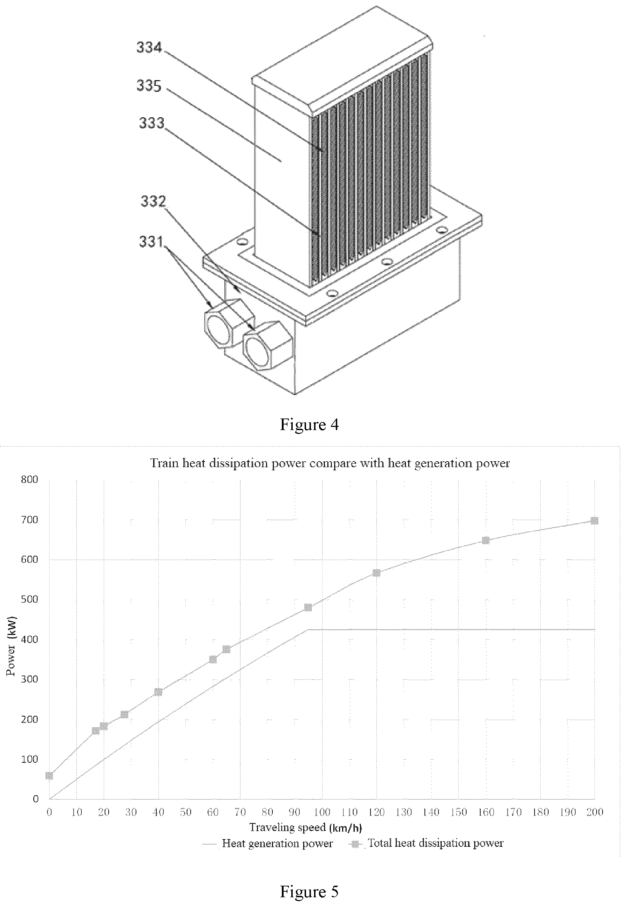

The heat dissipation module 33 can be a plate fin heat exchanger or a phase change heat dissipation apparatus. In this embodiment, the heat dissipation module 33 is a phase change heat dissipation apparatus. As shown in FIG. 4, the phase change heat dissipation apparatus includes a lower cavity 332, flow pipelines 331 disposed in the lower cavity 332, an upper cavity 335 disposed on the lower cavity 332, and multiple layers of phase change heat pipes 333 vertically stacked in parallel; an evaporation section of the phase change heat pipe 333 is disposed in the lower cavity 332, and a condensation section of the phase change heat pipe 333 is disposed in the upper cavity 335; and fins 334 are disposed on the evaporation section and/or condensation section of the phase change heat pipe and between two adjacent layers of phase change heat pipes 333, and at least some of the fins 334 are located in an air duct. Each phase change heat pipe includes an outer shell with a closed cavity, an inner shell coaxially disposed inside the outer shell, and a phase change working medium disposed between the outer shell and the inner shell. The regulating apparatus further controls each heat dissipation module 33 on each heat dissipation branch to open, thereby controlling the opening quantity of heat dissipation modules 33 on each heat dissipation branch. The heat dissipation modules 33 on each heat dissipation branch back up each other, thereby improving the reliability of the heat dissipation apparatus.

In a heat dissipation process, the liquid heat-conducting medium with stored heat flows into the lower cavity 332 through the flow pipelines 331 and transfers the heat to the evaporation sections of the phase change heat pipes 333 in the lower cavity 332, the heat is then transferred to the fins 334 through the condensation sections of the phase change heat pipes 333, finally the heat on the fins 334 is carried away through traveling air to reduce the temperature of the liquid heat-conducting medium and realize cooling of the liquid heat-conducting medium, the cooled liquid heat-conducting medium flows out of the lower cavity 332 and enters the next heat dissipation module 33 or flows back to the heat extraction apparatus 2 through the return pipeline 42. The phase change heat dissipation apparatus greatly improves the heat dissipation rate and effect through a heat transfer path of "liquid heat-conducting medium - phase change working medium - traveling air". By using the phase change heat dissipation technology, the heat conduction speed is fast, and the heat dissipation efficiency is high. In addition, heat is indirectly transferred between the liquid heat-conducting medium and an air side, which reduces leakage risk.

In this embodiment, the traveling air heat dissipation apparatus 3 is disposed at a roof, bottom, or side wall of the train. These mounting positions do not need to occupy special positions of the train, thereby saving space and reducing noise effect of the heat dissipation apparatus on the interior of the train. For example, the traveling air heat dissipation apparatus 3 is disposed on the roof, the air side of each heat dissipation module 33 is higher than or lower than a top plate of the train, the air side of the heat dissipation module is a fin side of the heat dissipation module, and traveling air dissipates heat of the heat dissipation module on the air side. An air duct is disposed at an inlet or outlet of the heat dissipation module 33 on the air side, the air duct being either trumpet-shaped or straight.

In this embodiment, the regulating apparatus is a module or device with control function, such as a programmable logic controller (PLC) or a microprocessor or a single chip microcomputer.

This embodiment further provides a method for dissipating heat by using the heat dissipation system described in Embodiment 1 above, including the following steps:

1. Heat generated by the heat generation devices 1 is collected by using the heat extraction apparatus 2 and stored in a liquid heat-conducting medium.

The liquid heat-conducting medium in the pipeline that is in close contact with the heat source in the heat generation device 1 absorbs heat generated by the heat source to collect the heat, and the heat is brought into the traveling air heat dissipation apparatus 3 by the heat-conducting pipeline 41 of the heat transfer apparatus 4 through flowing of the liquid heat-conducting medium in the pipeline, such that the heat in the liquid heat-conducting medium is dissipated through traveling air when the train runs, so that heat dissipation or cooling of the liquid heat-conducting medium is achieved.

2. The temperature sensor collects the temperature of the liquid heat-conducting medium in the outlet or inlet of the heat extraction apparatus 2 and transmits the temperature to the regulating apparatus.

Conduction of the heat in the heat generation device is achieved through the liquid heat-conducting medium. The temperature of the liquid heat-conducting medium in the outlet of the heat extraction apparatus 2 reflects the heat generated by the heat generation device 1, and the temperature of the liquid heat-conducting medium in the inlet of the heat extraction apparatus 2 reflects the heat generated by the heat generation device 1 that can be stored in the liquid heat-conducting medium (the lower temperature of the liquid heat-conducting medium indicates that more heat can be stored). Therefore, on the basis of the original opening quantity of heat dissipation modules 33 and the original flow rate of the liquid heat-conducting medium, the heat dissipation value is regulated by monitoring the temperature of the liquid heat-conducting medium in the outlet or inlet of the heat extraction apparatus 2 and increasing or decreasing the opening quantity of heat dissipation modules 33 and/or increasing or decreasing the flow rate of the liquid heat-conducting medium in the traveling air heat dissipation apparatus 3, such that the temperature of the liquid heat-conducting medium in the outlet or inlet of the heat extraction apparatus 2 is within a threshold range, the heat generation device 1 works within a suitable temperature range, balance control on a heat generation value and a heat dissipation value is achieved, and a purpose of efficient and low-energy heat dissipation is achieved.

3. The opening quantity of heat dissipation modules 33 in the traveling air heat dissipation apparatus 3 and/or the flow rate of the liquid heat-conducting medium in the traveling air heat dissipation apparatus 3 are controlled according to the temperature of the liquid heat-conducting medium in the outlet or inlet of the heat extraction apparatus 2, such that the temperature of the liquid heat-conducting medium in the outlet or inlet of the heat extraction apparatus 2 is within the threshold range, and balance control on a heat generation value and a heat dissipation value is achieved,

If the heat generated by the $i^{th}$ heat generation device 1 is $Q_{cri}(v)$, the total heat $Q_{crk}$ generated by the $k$ heat generation devices 1 is:

$$Q_{crk} = \sum_{i=1}^{k} Q_{cri}(v) \quad (1)$$

where $v$ is a traveling speed of the train, and the heat generated by a single heat generation device 1 varies with the change in the traveling speed $v$ of the train. The higher traveling speed of the train indicates more heat generated by the single heat generation device 1. If the heat dissipation value of a single heat dissipation module 33 is $Q_{srij}(v, q)$, the total heat dissipation value $Q_{srnm}$ of $n \times m$ heat dissipation modules 33 is:

$$Q_{srnm} = \sum_{i=1}^{n} \sum_{j=1}^{m} Q_{srij}(v, q) \quad (2)$$

where $q$ is a flow rate of the liquid heat-conducting medium. The heat dissipation value is related to not only the traveling speed $v$ of the train, but also the flow rate $q$ of the liquid heat-conducting medium. The higher traveling speed $v$ indicates a higher speed of the traveling air, a larger heat dissipation value, and a larger flow rate $q$ of the liquid heat-conducting medium. When the flow rate $q$ is fixed, the heat dissipation value of each heat dissipation module 33 follows the law of formula (3):

$$Q_{srij}(v) = a \ln v + b \quad (3)$$

where $a$ and $b$ are constants.

The heat per unit time is power, that is, the total heat per unit time is equal to total heat generation power, and the total heat dissipation value per unit time is heat dissipation power. A calculation formula for the total heat generation power is:

$$P_{cr}(v) = \lambda \times F(v) \times v \quad (4)$$

where $P_{cr}(v)$ is total heat generation power corresponding to the traveling speed, $F(v)$ is train traction force corresponding to the traveling speed, $v$ is a traveling speed of the train, $\lambda$ is a power loss coefficient, and a value range of $\lambda$ is 0.5%-30% according to different vehicle models. In this embodiment, $\lambda$ is 3.2% or 4.3%. Calculation of the train traction force and obtaining of the traveling speed of the train are existing technologies, and their processes will not be detailed here.

Relationships between the heat generation power and heat dissipation power of the heat dissipation apparatus under a rated condition and the traveling speed in Embodiment 1 can be obtained according to experiments, as shown in FIG. 5. From FIG. 5, it can be seen that the heat dissipation value of the heat dissipation apparatus under the rated condition has to be greater than the heat generation value to ensure effective heat dissipation of the heat generation device. However, in actual work, the heat dissipation apparatus cannot always work under the rated condition. Therefore, the heat dissipation value needs to be regulated to equal to the heat generation value in actual work. From FIG. 5, it may also be seen that different traveling speeds correspond to different heat dissipation power, the higher traveling speed indicates higher heat dissipation power and heat generation power, and when the traveling speed reaches a certain value (such as 95 km/h), the heat dissipation power continues to increase and the heat generation power remains unchanged. When the traveling speed of the train is greater than 95 km/h, the heat dissipation power is basically proportional to the traveling speed, and the heat dissipation value per unit volume of the heat dissipation module 33 is higher than that of a conventional forced air-cooled radiator. Therefore, the heat dissipation system in Embodiment 1 can achieve effective heat dissipation of the heat generation device 1, especially during high-speed traveling of the train. When the train travels at a high speed, the heat dissipation of the heat generation device 1 can be achieved by using the traveling air heat dissipation apparatus 3.

On the basis of the original opening quantity of heat dissipation modules 33 and the original flow rate of the liquid heat-conducting medium, the opening quantity of heat dissipation modules 33 and/or the flow rate of the liquid heat-conducting medium are continuously adjusted according to the temperature of the liquid heat-conducting medium in the outlet or inlet of the heat dissipation apparatus 2, such that the temperature of the liquid heat-conducting medium in the outlet or inlet of the heat extraction apparatus 2 is maintained within a threshold range, the heat generation device 1 works within a suitable temperature range, and balance between a heat generation value and a heat dissipation value is achieved. Specifically:

When the temperature of the liquid heat-conducting medium in the outlet or inlet of the heat extraction apparatus 2 is higher than a maximum value of the threshold range, the opening quantity of heat dissipation modules 33 and/or the flow rate of the liquid heat-conducting medium are increased to increase the heat dissipation value and balance the heat generation value and the heat dissipation value; or when the temperature of the liquid heat-conducting medium in the outlet or inlet of the heat extraction apparatus 2 is lower than a minimum value of the threshold range, the opening quantity of heat dissipation modules 33 and/or the flow rate of the liquid heat-conducting medium are decreased to decrease the heat dissipation value, reduce energy consumption, and balance the heat generation value and the heat dissipation value.

**Embodiment 2**

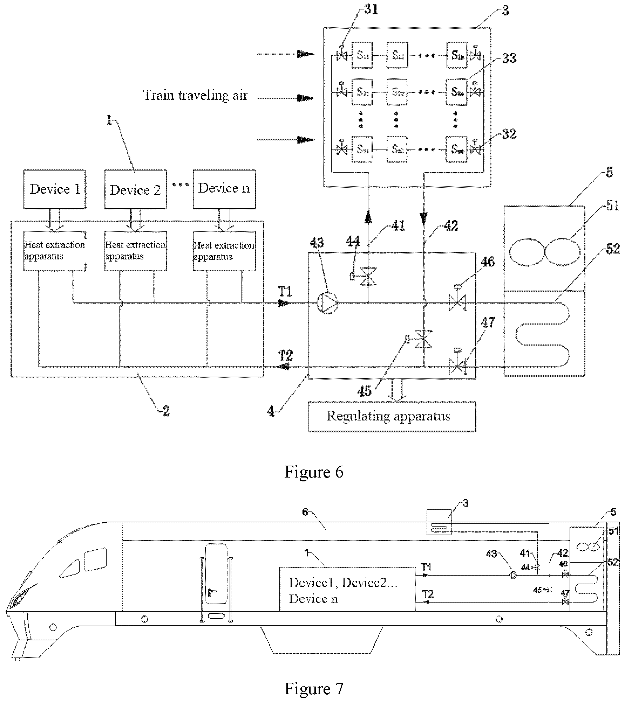

As shown in FIG. 6, a rail train heat dissipation system provided in this embodiment includes a heat extraction apparatus 2, a temperature sensor, a heat transfer apparatus 4, a traveling air heat dissipation apparatus 3, a vehicle-mounted cooling apparatus 5, and a regulating apparatus. The heat extraction apparatus 2 is connected to the heat transfer apparatus 4, and the heat transfer apparatus 4 is connected to the traveling air heat dissipation apparatus 3 and the vehicle-mounted cooling apparatus 5 respectively. The temperature sensor is disposed at an outlet or inlet of the heat extraction apparatus 2. The regulating apparatus calculates total heat generation power of all heat generation devices 1, and controls the traveling air heat dissipation apparatus 3 to open or the traveling air heat dissipation apparatus 3 and the vehicle-mounted cooling apparatus 5 to open according to the total heat generation power; when only the traveling air heat dissipation apparatus 3 is opened, an opening quantity of heat dissipation modules 33 and/or a flow rate of a liquid heat-conducting medium are controlled according to the method in Embodiment 1, such that the temperature of the liquid heat-conducting medium in the outlet or inlet of the heat extraction apparatus 2 is within a threshold range, and balance control on a heat generation value and a heat dissipation value is achieved; or when the traveling air heat dissipation apparatus 3 and the vehicle-mounted cooling apparatus 5 are opened, all the heat dissipation modules 33 in the traveling air heat dissipation apparatus 3 are controlled to be opened, the flow rate of the liquid heat-conducting medium in the traveling air heat dissipation apparatus 3 is controlled to be maximum (even if the traveling air heat dissipation apparatus 3 works at maximum heat dissipation power), and heat dissipation power of the vehicle-mounted cooling apparatus 5 is controlled according to the temperature of the liquid heat-conducting medium in the outlet or inlet of the heat extraction apparatus 2, such that the temperature of the liquid heat-conducting medium in the outlet or inlet of the heat extraction apparatus 2 is within a threshold range, and balance control on a heat generation value and a heat dissipation value is achieved.

As shown in FIG. 6, the heat transfer apparatus 4 further includes a first branch and a second branch on the basis of Embodiment 1, and a third valve 46 and a fourth valve 47 are disposed on the first branch and the second branch separately. When only the traveling air heat dissipation apparatus 3 is opened, the regulating apparatus controls the first valve 44 and the second valve 45 to open and the third valve 46 and the fourth valve 47 to close, and the liquid heat-conducting medium flows into only the traveling air heat dissipation apparatus 3 for heat dissipation; and when the traveling air heat dissipation apparatus 3 and the vehicle-mounted cooling apparatus 5 are opened, the regulating apparatus controls the first valve 44, the second valve 45, the third valve 46, and the fourth valve 47 to open, and the liquid heat-conducting medium flows into the traveling air heat dissipation apparatus 3 and the vehicle-mounted cooling apparatus 5 for heat dissipation.

The vehicle-mounted cooling apparatus 5 is a conventional cooling device, such as a vehicle-mounted cooling tower. The vehicle-mounted cooling tower includes a fan 51 and a cooling tower heat exchanger 52, and the vehicle-mounted cooling tower dissipates heat through the fan 51 and the cooling tower heat exchanger 52. The heat dissipation value of the traveling air heat dissipation apparatus 3 increases with the increase of traveling speed of the train, and decreases with the decrease of traveling speed of the train. During start or low-speed operation of the train, although the heat generation power of the heat generation device 1 is small, the heat dissipation value of the traveling air heat dissipation apparatus 3 is correspondingly small, and the heat dissipation power is partially lost, which may not guarantee effective heat dissipation of the heat generation device 1. In order to ensure the effective heat dissipation of the heat generation device 1 during start, low-speed operation, or deceleration operation of the train, the vehicle-mounted cooling apparatus 5 is added in this embodiment. Controlling the traveling air heat dissipation apparatus 3 to open or the traveling air heat dissipation apparatus 3 and the vehicle-mounted cooling apparatus 5 to open according to the total heat generation power, specifically:

When the total heat generation power $P_{cr}(v)$ is less than or equal to $P_{sr} \times \lambda_{sh}$, the regulating apparatus controls the traveling air heat dissipation apparatus 3 to open, and then controls the opening quantity of heat dissipation modules 33 in the traveling air heat dissipation apparatus 3 and/or the flow rate of the liquid heat-conducting medium in the traveling air heat dissipation apparatus 3 according to the method in Embodiment 1, such that the temperature of the liquid heat-conducting medium in the outlet or inlet of the heat extraction apparatus 2 is within a threshold range, and balance control on a heat generation value and a heat dissipation value is achieved; or When the total heat generation power $P_{cr}(v)$ is greater than $P_{sr} \times \lambda_{sh}$, the regulating apparatus controls the traveling air heat dissipation apparatus 3 and the vehicle-mounted cooling apparatus 5 to open, all the heat dissipation modules 33 in the traveling air heat dissipation apparatus 3 are opened and the flow rate of the liquid heat-conducting medium in the traveling air heat dissipation apparatus 3 is maximum to ensure that the traveling air heat dissipation apparatus 3 works at maximum heat dissipation power, and heat dissipation power of the vehicle-mounted cooling apparatus 5 is then controlled according to the temperature of the liquid heat-conducting medium in the outlet or inlet of the heat extraction apparatus 2, such that the temperature of the liquid heat-conducting medium in the outlet or inlet of the heat extraction apparatus 2 is within a threshold range, and balance control on a heat generation value and a heat dissipation value is achieved.

$P_{sr}$ is heat dissipation power of the traveling air heat dissipation apparatus 3, $\lambda_{sh}$ is a heat dissipation loss coefficient, and $P_{sr}^{\max}$ is maximum heat dissipation power of the traveling air heat dissipation apparatus 3. The total heat dissipation power can be calculated from formula (4), and the heat dissipation power of the traveling air heat dissipation apparatus 3 can be obtained from the relationship curve between the traveling speed of the train and the heat dissipation power, as shown in FIG. 5. The portion of heat that cannot be dissipated by the traveling air heat dissipation apparatus 3 (namely, heat corresponding to $P_{cr} - P_{sr}^{\max} \times \lambda_{sh}$) is dissipated by the vehicle-mounted cooling apparatus 5, which achieves balance control on a heat generation value and a heat dissipation value and achieves effective heat dissipation of the heat generation device 1. This control method is based on the principle of prioritizing the heat dissipation of the traveling air heat dissipation apparatus 3. The heat dissipation is only compensated by the vehicle-mounted cooling apparatus 5 when the heat dissipation power of the traveling air heat dissipation apparatus 3 is insufficient. This not only ensures that the heat generation device 1 works within a suitable temperature range, but also saves energy consumption and reduces noise.

In this embodiment, the heat dissipation loss coefficient $\lambda_{sh}$=(rated heat dissipation power of the heat dissipation apparatus - actual heat dissipation power)/rated heat dissipation power, and a value of the heat dissipation loss coefficient $\lambda_{sh}$ is generally 0-20%.

FIG. 7 shows disposal of the traveling air heat dissipation apparatus 3 and the vehicle-mounted cooling apparatus 5 on a train. The traveling air heat dissipation apparatus 3 is disposed on the roof, and the air side of the heat dissipation module 33 is higher than or lower than a top plate of the train. The mounting position does not need to occupy a special position of the train, thereby saving space and reducing noise effect of the heat dissipation apparatus on the interior of the train.

This embodiment further provides a method for dissipating heat by using the heat dissipation system described in Embodiment 2 above, including the following steps:

1. Heat generated by the heat generation devices 1 is collected by using the heat extraction apparatus 2 and stored in a liquid heat-conducting medium.
2. The temperature sensor collects the temperature of the liquid heat-conducting medium in the outlet or inlet of the heat extraction apparatus 2 and transmits the temperature to the regulating apparatus.
3. The total heat generation power of all the heat generation devices 1 is calculated according to formula (4).

Steps 2 and 3 have no chronological order. 4. Controlling the traveling air heat dissipation apparatus 3 to open or the traveling air heat dissipation apparatus 3 and the vehicle-mounted cooling apparatus 5 to open according to the total heat generation power.

When the total heat generation power $P_{cr}(v)$ is less than or equal to $P_{sr} \times \lambda_{sh}$, the regulating apparatus controls the the traveling air heat dissipation apparatus 3 to open, and then controls the opening quantity of heat dissipation modules 33 in the traveling air heat dissipation apparatus 3 and/or the flow rate of the liquid heat-conducting medium in the traveling air heat dissipation apparatus 3 according to the method of step 3 in Embodiment 1, such that the temperature of the liquid heat-conducting medium in the outlet or inlet of the heat extraction apparatus 2 is within a threshold range, and balance control on a heat generation value and a heat dissipation value is achieved. When the total heat generation power $P_{cr}(v)$ is greater than $P_{sr} \times \lambda_{sh}$, the regulating apparatus controls the traveling air heat dissipation apparatus 3 and the vehicle-mounted cooling apparatus 5 to be opened, all the heat dissipation modules 33 in the traveling air heat dissipation apparatus 3 to be opened, and the flow rate of the liquid heat-conducting medium in the traveling air heat dissipation apparatus 3 to be maximum, so as to ensure that the traveling air heat dissipation apparatus 3 works at maximum heat dissipation power. Heat dissipation power of the vehicle-mounted cooling apparatus 5 is then controlled according to the temperature of the liquid heat-conducting medium in the outlet or inlet of the heat extraction apparatus 2, such that the temperature of the liquid heat-conducting medium in the outlet or inlet of the heat extraction apparatus 2 is within a threshold range, and balance control on a heat generation value and a heat dissipation value is achieved.

Described above are the specific embodiments of the present invention only, but the protection scope of the present invention is not limited thereto. Any skilled person who is familiar with this art could readily conceive of variations or modifications within the disclosed technical scope of the present invention, and these variations or modifications shall fall within the protection scope of the present invention.

**Claims**

1. A rail train heat dissipation system, **characterized in that**, comprising:

   a heat extraction apparatus used for collecting heat of heat generation devices and storing the heat in a liquid heat-conducting medium;
   a temperature sensor disposed at an outlet or inlet of the heat extraction apparatus and used for detecting the temperature of the liquid heat-conducting medium in the outlet or inlet;
   a heat transfer apparatus connected to the heat extraction apparatus and used for transferring the liquid heat-conducting medium with stored heat to the heat dissipation apparatus and transferring the cooled liquid heat-conducting medium to the heat extraction apparatus;
   a traveling air heat dissipation apparatus connected to the heat transfer apparatus and used for dissipate heat of the incoming liquid heat-conducting medium; and
   a regulating apparatus used for controlling an opening quantity of heat dissipation modules in the traveling air heat dissipation apparatus and/or a flow rate of the liquid heat-conducting medium in the traveling air heat dissipation apparatus according to the temperature of the liquid heat-conducting medium in the outlet or inlet of the heat extraction apparatus, such that the temperature of the liquid heat-conducting medium in the outlet or inlet of the heat extraction apparatus is within a threshold range.

**2.** The rail train heat dissipation system according to claim 1, wherein the traveling air heat dissipation apparatus comprises a plurality of heat dissipation branches; each heat dissipation branch comprises a plurality of heat dissipation modules connected in series or in parallel or in series and parallel; an input valve is disposed at an input end of each heat dissipation branch, and an output valve is disposed at an output end of each heat dissipation branch; and the input end of each heat dissipation branch is connected to a heat-conducting pipeline of the heat transfer apparatus, and the output end of each heat dissipation branch is connected to a return pipeline of the heat transfer apparatus.

**3.** The rail train heat dissipation system according to claim 1, wherein the traveling air heat dissipation apparatus is disposed at a roof, bottom, or side wall of a train.

**4.** The rail train heat dissipation system according to claim 1, wherein the heat dissipation module is a phase change heat dissipation apparatus, which comprises a lower cavity, flow pipelines disposed in the lower cavity, an upper cavity disposed on the lower cavity, and multiple layers of phase change heat pipes stacked in parallel; an evaporation section of the phase change heat pipe is disposed in the lower cavity, and a condensation section of the phase change heat pipe is disposed in the upper cavity; and fins are disposed on the condensation section of the phase change heat pipe and between two adjacent layers of phase change heat pipes; and at least some of the fins are located in an air duct.

**5.** The rail train heat dissipation system according to any one of claims 1-4, further comprising a vehicle-mounted cooling apparatus connected to the heat transfer apparatus, wherein
the regulating apparatus is further used for calculating total heat generation power of all the heat generation devices, and controlling the traveling air heat dissipation apparatus to open or the traveling air heat dissipation apparatus and the vehicle-mounted cooling apparatus to open according to the total heat generation power.

**6.** A method for dissipating heat by using the heat dissipation system according to any one of claims 1-5, comprising the following steps:

step 1: collecting heat generated by the heat generation devices and storing the heat in a liquid heat-conducting medium;
step 2: obtaining the temperature of the liquid heat-conducting medium in the outlet or inlet of the heat extraction apparatus; and
step 3: controlling an opening quantity of heat dissipation modules in the traveling air heat dissipation apparatus and/or a flow rate of the liquid heat-conducting medium in the traveling air heat dissipation apparatus according to the temperature of the liquid heat-conducting medium in the outlet or inlet of the heat extraction apparatus, such that the temperature of the liquid heat-conducting medium in the outlet or inlet of the heat extraction apparatus is within a threshold range.

**7.** The method according to claim 6, wherein in step 3, a process of controlling an opening quantity of heat dissipation modules and/or a flow rate of the liquid heat-conducting medium is as follows:

when the temperature of the liquid heat-conducting medium in the outlet or inlet of the heat extraction apparatus is higher than a maximum value of the threshold range, increasing the opening quantity of heat dissipation modules and/or increasing the flow rate of the liquid heat-conducting medium; or
when the temperature of the liquid heat-conducting medium in the outlet or inlet of the heat extraction apparatus is lower than a minimum value of the threshold range, decreasing the opening quantity of heat dissipation modules and/or decreasing the flow rate of the liquid heat-conducting medium, wherein
the threshold range is set according to a working temperature range of the heat generation devices.

**8.** The method according to claim 6 or 7, wherein after step 1 and before step 3, the method further comprises:

calculating total heat generation power of all the heat generation devices;
controlling the traveling air heat dissipation apparatus to open or the traveling air heat dissipation apparatus and the vehicle-mounted cooling apparatus to open according to the total heat generation power; and
performing step 3 when only the traveling air heat dissipation apparatus is opened; or
when both the traveling air heat dissipation apparatus and the vehicle-mounted cooling apparatus are opened, controlling all heat dissipation modules in the traveling air heat dissipation apparatus to be opened, controlling the flow rate of the liquid heat-conducting medium in the traveling air heat dissipation apparatus to be maximum, and controlling heat dissipation power of the vehicle-mounted cooling apparatus according to the temperature of the liquid heat-conducting medium in the outlet or inlet of the heat extraction apparatus, such that the temperature of the liquid heat-conducting medium in the outlet or inlet of the heat extraction apparatus is within the threshold range.

9. The method according to claim 8, wherein an expression for calculating the total heat generation power is:

$$P_{cr}(v) = \lambda \times F(v) \times v$$

wherein $P_{cr}(v)$ is total heat generation power corresponding to a traveling speed, $F(v)$ is train traction force corresponding to the traveling speed, $v$ is a traveling speed of the train, $\lambda$ is a power loss coefficient, and a value range of $\lambda$ is 0.5%-30% according to different vehicle models.

10. A rail train, comprising the heat dissipation system according to any one of claims 1-5.

Figure 1

Figure 2

Figure 3

Figure 4

Figure 5

Train traveling air

Regulating apparatus

Figure 6

Device1, Device2...
Device n

Figure 7

**EP 4 280 831 A1**

## INTERNATIONAL SEARCH REPORT

| International application No. |
|---|
| **PCT/CN2021/121624** |

| A. | CLASSIFICATION OF SUBJECT MATTER |
|---|---|
| | H05K 7/20(2006.01)i |

According to International Patent Classification (IPC) or to both national classification and IPC

| B. | FIELDS SEARCHED |
|---|---|

Minimum documentation searched (classification system followed by classification symbols)
    H05K

Documentation searched other than minimum documentation to the extent that such documents are included in the fields searched

Electronic data base consulted during the international search (name of data base and, where practicable, search terms used)
    CNPAT, CNKI, WPI, EPODOC: 列车, 轨道, 散热, 走行风, 温度, 传感器, 调整, 调节, 控制, 阈值, 门限, train, rail, heat dissipation, walk, run, wind, air, temperature, sensor, adjust, control, threshold

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 112954952 A (CRRC ZHUZHOU LOCOMOTIVE CO., LTD.) 11 June 2021 (2021-06-11) claims 1-10 | 1-10 |
| Y | CN 111526693 A (ZHUZHOU CRRC TIMES ELECTRIC CO., LTD.) 11 August 2020 (2020-08-11) description, paragraphs 0031-0041 | 1-10 |
| Y | CN 106314110 A (FARADAY (BEIJING) NETWORK TECHNOLOGY CO., LTD.) 11 January 2017 (2017-01-11) claims 1-7 | 1-10 |
| A | CN 111654997 A (CRRC ZHUZHOU INSTITUTE CO., LTD.) 11 September 2020 (2020-09-11) entire document | 1-10 |
| A | CN 209553190 U (SHIJIAZHUANG TONGDA LOCOMOTIVE EQUIPMENT CO., LTD.) 29 October 2019 (2019-10-29) entire document | 1-10 |
| A | WO 0169056 A1 (PEUGEOT CITROEN AUTOMOBILES) 20 September 2001 (2001-09-20) entire document | 1-10 |

☑ Further documents are listed in the continuation of Box C.     ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **17 December 2021** | **29 December 2021** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

| International application No. |
| --- |
| **PCT/CN2021/121624** |

**C.     DOCUMENTS CONSIDERED TO BE RELEVANT**

| Category* | Citation of document, with indication, where appropriate, of the relevant passages | Relevant to claim No. |
| --- | --- | --- |
| A | EP 2187136 A2 (BRUENING, OLAF) 19 May 2010 (2010-05-19)<br>entire document | 1-10 |

Form PCT/ISA/210 (second sheet) (January 2015)

**INTERNATIONAL SEARCH REPORT**
Information on patent family members

International application No.

**PCT/CN2021/121624**

| Patent document cited in search report | | | Publication date (day/month/year) | Patent family member(s) | | | Publication date (day/month/year) |
|---|---|---|---|---|---|---|---|
| CN | 112954952 | A | 11 June 2021 | None | | | |
| CN | 111526693 | A | 11 August 2020 | None | | | |
| CN | 106314110 | A | 11 January 2017 | None | | | |
| CN | 111654997 | A | 11 September 2020 | None | | | |
| CN | 209553190 | U | 29 October 2019 | None | | | |
| WO | 0169056 | A1 | 20 September 2001 | EP | 1264086 | A1 | 11 December 2002 |
| | | | | US | 2003196612 | A1 | 23 October 2003 |
| | | | | ES | 2273806 | T3 | 16 May 2007 |
| | | | | JP | 2003528241 | A | 24 September 2003 |
| | | | | FR | 2806444 | A1 | 21 September 2001 |
| | | | | DE | 60123587 | D1 | 16 November 2006 |
| EP | 2187136 | A2 | 19 May 2010 | DE | 102008057730 | A1 | 20 May 2010 |

Form PCT/ISA/210 (patent family annex) (January 2015)